# EUROPÄISCHE PATENTSCHRIFT

(11) **EP 0 744 771 B1**
(45) Veröffentlichungstag und Bekanntmachung des Hinweises auf die Patenterteilung: **29.08.2001**
(21) Anmeldenummer: 96107433.3
(22) Anmeldetag: 10.05.1996
(51) Int. Cl.: H01L 27/108, H01L 21/8242

(54) **Verfahren zur Herstellung einer DRAM-Speicherzelle mit vertikalem Transistor**
Method of making a DRAM storage cell with a vertical transistor
Procédé de fabrication d'une cellule de stockage DRAM avec transistor vertical

(30) Priorität: 24.05.1995 DE 19519160
(43) Veröffentlichungstag der Anmeldung: 27.11.1996
(73) Patentinhaber: Infineon Technologies AG, 81669 München (DE)
(72) Erfinder: Rösner, Wolfgang, Dr., 81739 München (DE); Risch, Lothar, Dr., 85579 Neubiberg (DE); Hofmann, Franz, Dr., 80995 München (DE); Krautschneider, Wolfgang, Dr., 83104 Hohenthann (DE)
(74) Vertreter: Zedlitz, Peter, Dipl.-Inf.

(56) Entgegenhaltungen:
- EP-A- 0 453 998
- EP-A- 0 516 031
- US-A- 5 307 310
- 1993 SYMPOSIUM ON VLSI TECHNOLOGY - DIGEST OF TECHNICAL PAPERS, Bd. 3A, Nr. 2, 17. - 19.Mai 1993, KYOTO, JAPAN, Seiten 19-20, XP000462894 M. SAKAO ET AL.: "A Straight-Line-Trench Isolation and Trench-Gate Transistor (SLIT) Cell for Giga-bit DRAMs"
- PATENT ABSTRACTS OF JAPAN vol. 13, no. 594 (E-867) [3942] , 27.Dezember 1989 & JP-A-01 248557 (TOSHIBA CORP), 4.Oktober 1989,
- PATENT ABSTRACTS OF JAPAN vol. 14, no. 479 (E-992), 18.Oktober 1990 & JP-A-02 198170 (HITACHI LTD), 6.August 1990,
- PATENT ABSTRACTS OF JAPAN vol. 9, no. 140 (E-321), 14.Juni 1985 & JP-A-60 021558 (MITSUBISHI DENKI K.K.), 2.Februar 1985,

## Beschreibung

In DRAM-Zellenanordnungen, das heißt, Speicherzellenanordnungen mit dynamischem, wahlfreiem Zugriff, werden fast ausschließlich sogenannte Eintransistor-Speicherzellen eingesetzt. Eine Eintransistorspeicherzelle umfaßt einen Auslesetransistor und einen Speicherkondensator. In dem Speicherkondensator ist die Information in Form einer elektrischen Ladung gespeichert, die eine logische Größe, Null oder Eins, darstellt. Durch Ansteuerung des Auslesetransistors über eine Wortleitung kann diese Information über eine Bitleitung ausgelesen werden.

Da von Speichergeneration zu Speichergeneration die Speicherdichte zunimmt, muß die benötigte Fläche der Eintransistorspeicherzelle von Generation zu Generation reduziert werden. Da der Reduktion der Strukturgrößen durch die minimale in der jeweiligen Technologie herstellbare Strukturgröße F Grenzen gesetzt sind, ist dies auch mit einer Veränderung der Eintransistorspeicherzelle verbunden. So wurden bis zur 1MBit-Generation sowohl der Auslesetransistor als auch der Speicherkondensator als planare Bauelemente realisiert. Ab der 4MBit-Speichergeneration mußte eine weitere Flächenreduzierung durch eine dreidimensionale Anordnung von Auslesetransistor und Speicherkondensator erfolgen. Eine Möglichkeit besteht darin, den Speicherkondensator in einem Graben zu realisieren (siehe zum Beispiel K. Yamada et al, A deep trenched capacitor technology for 4 Mbit DRAMs, Proc. Intern. Electronic Devices and Materials IEDM 85, Seite 702).

Ferner ist vorgeschlagen worden (siehe zum Beispiel Y. Kawamoto et al, A 1,28 µm² Bit-Line Shielded Memory Cell Technology for 64 Mbit DRAMs Techn. Digest of VLSI Symposium 1990, Seite 13) den Speicherkondensator als Stapelkondensator, den sogenannten stacked capacitor, auszuführen. Dabei wird über den Wortleitungen eine Struktur aus Polysilizium, zum Beispiel eine Kronenstruktur oder ein Zylinder gebildet, der mit dem Substrat kontaktiert wird. Diese Polysiliziumstruktur bildet den Speicherknoten. Er wird mit Kondensatordielektrikum und Kondensatorplatte versehen. Dieses Konzept hat den Vorzug, daß es weitgehend mit einem Logikprozeß kompatibel ist.

Die Fläche für eine Speicherzelle eines DRAM in der lGBit-Generation soll nur etwa 0,2 µm² betragen. Der Speicherkondensator muß dabei eine Kapazität von 20 bis 30 fF aufweisen. Eine derartige Kapazität ist bei einer Zellfläche, wie sie bei der 1GBit-Generation zur Verfügung steht, in einem Stapelkondensator nur mit einer relativ komplizierten Struktur der Polysiliziumstruktur machbar. Diese komplizierten Strukturen sind zusätzlich durch ihre Topologie immer schwieriger herstellbar.

Ferner ist vorgeschlagen worden, die pro Fläche erzielbare Kapazität durch Verwendung eines Dielektrikum mit einer hohen Dielektrizitätskonstante zu erhöhen. Als Dielektrikum mit hoher Dielektrizitätskonstante sind insbesondere Para- und Ferroelektrika geeignet (siehe zum Beispiel WO 93/12542).

Aus EP 0 453 998 A1 ist eine DRAM-Zellenanordnung und ein Verfahren zu deren Herstellung bekannt, bei der als Speicherzelle vertikale MOS-Transistoren und Speicherkondensatoren verwendet werden. Die vertikalen MOS-Transistoren werden an den Flanken von Halbleitersäulen realisiert, die von einer Gateelektrode ringförmig umgeben sind. In der Speicherzellenanordnung werden die Bitleitungen durch selektive Epitaxie, die teilweise über eine isolierende Struktur wächst, gebildet. Die isolierende Struktur kann sowohl in einem Substrat vergraben als auch an der Oberfläche eines Substrats angeordnet sein.

Aus EP 0 516 031 A1 ist eine Speicherzelle mit einem planaren Auswahltransistor und einem Speicherkondensator bekannt, bei der der Speicherkondensator als Kondensatordielektrikum eine ferroelektrische Schicht aufweist und der Speicherkondensator oberhalb des Auswahltransistors angeordnet ist.

Der Erfindung liegt das Problem zugrunde, ein Herstellverfahren für eine DRAM-Zellenanordnung anzugeben, die als Speicherzellen Eintransistorspeicherzellen umfaßt und die in der für die 1GBit-Generation erforderlichen Packungsdichte herstellbar ist.

Dieses Problem wird gelöst durch ein Verfahren gemäß Anspruch 1. Weitere Ausgestaltungen der Erfindung gehen aus den übrigen Ansprüchen hervor.

In der erfindungsgemäß hergestellten DRAM-Zellenanordnung sind Eintransistorspeicherzellen vorgesehen, in denen der Auslesetransistor als vertikaler MOS-Transistor ausgebildet ist. Dabei grenzt ein erstes Source/Drain-Gebiet des vertikalen MOS-Transistors an eine Hauptfläche eines Halbleitersubstrats, in dem die DRAM-Zellenanordnung realisiert ist, an. Das zweite Source/Drain-Gebiet grenzt an eine vergrabene Bitleitung an.

Der Speicherkondensator ist oberhalb der Hauptfläche angeordnet. Er umfaßt einen Speicherknoten, der mit dem ersten Source/Drain-Gebiet elektrisch verbunden ist. Der Speicherknoten kann sowohl planar als auch als mehr oder weniger komplizierte Polysiliziumstruktur, wie es von den Stapelkondensatoren her bekannt ist, ausgebildet sein.

Auf der Hauptfläche ist gemäß einer Ausführungsform an der Oberfläche des dort angrenzenden, ersten Source/Drain-Gebietes ein Kondensatordielektrikum und darüber eine Kondensatorplatte angeordnet. Das an die Hauptfläche angrenzende erste Source/Drain-Gebiet wird in dieser Ausführungsform zusätzlich als Speicherknoten für den aus Kondensatorplatte, Kondensatordielektrikum und Source/Drain-Gebiet gebildeten Speicherkondensator verwendet. Um bei einer kleinen Fläche des Speicherknotens eine ausreichende Kapazität zu erzielen, ist es dabei vorteilhaft, als Kondensatordielektrikum ein Material mit einer relativen Dielektrizitätskonstante im Bereich zwischen 100 und 1000 zu verwenden.

Zwischen dem ersten Source/Drain-Gebiet und dem zweiten Source/Drain-Gebiet ist im Halbleitersubstrat ein Kanalgebiet angeordnet, das von einem Gateoxid und einer Gateelektrode ringförmig umgeben wird. Die Gateelektroden von entlang einer Wortleitung benachbarten vertikalen MOS-Transistoren grenzen aneinander an.

Die DRAM-Zellenanordnung wird vorzugsweise in einem Halbleitersubstrat realisiert, das mindestens in dem Bereich für die DRAM-Zellenanordnung monokristallines Silizium umfaßt. Das kann sowohl eine Scheibe durchgehend aus monokristallinem Silizium als auch ein SOI-Substrat, das auf einer Siliziumscheibe eine isolierende Schicht und darauf eine dünne monokristalline Siliziumschicht umfaßt, sein.

Die erfindungsgemäß hergestellte DRAM-Zellenanordnung kann bei Verwendung des ersten Source/Drain-Gebietes als Speicherknoten mit einer planaren Oberfläche oder mit einer Oberfläche mit einer flachen Topologie hergestellt werden, so daß als Kondensatordielektrikum eine ferroelektrische Schicht oder paraelektrische Schicht verwendet werden kann. Ferroelektrische und paraelektrische Schichten weisen eine hohe relative Dielektrizitätskonstante εᵣ im Bereich von 500 bis 1000 auf. Wenn diese Schichten durch Sputtern abgeschieden werden, sind sie nur auf ebenen Oberflächen oder Oberflächen mit einer flachen Topologie einsetzbar. Auch bei CVD- oder Sol-Gel-Verfahren mit besserer Kantenbedeckung können durch die benötigte Dicke der Schichten keine komplizierten 3D-Strukturen hergestellt werden. Als Kondensatordielektrikum wird vorzugsweise Barium-Strontium-Titanat, Strontium-Titanat oder Blei-Zirkon-Titanat verwendet. Ferner sind die aus WO 93/12542 bekannten Materialien als Kondensatordielektrikum geeignet. Mit diesen Dielektrika mit hoher relativer Dielektrizitätskonstante kann die erforderliche Kapazität von 20 bis 30 fF auch auf einer Fläche von etwa 0,1 bis 0,4 µm² erzielt werden.

Es liegt im Rahmen der Erfindung, daß die Wortleitungen jeweils aus den aneinandergrenzenden Gateelektroden gebildet werden.

Die Herstellung der DRAM-Zellenanordnung erfolgt in einem selbstjustierenden Verfahren. Dabei werden in dem Halbleitersubstrat sich über den Bereich für die DRAM-Zellenanordnung erstreckende Gebiete mit entsprechenden Dotierungen für die Source/Drain-Gebiete und das dazwischen angeordnete Kanalgebiet erzeugt. Anschließend werden erste Gräben erzeugt, die die Gebiete für die Source/Drain-Gebiete, das Kanalgebiet und die Bitleitungen durchtrennen. Bei der Ätzung der ersten Gräben werden somit die Bitleitungen definiert. Nach Auffüllen der ersten Gräben mit einer Isolationsstruktur werden dazu quer verlaufende zweite Gräben geätzt, die die Gebiete für die Source/Drain-Gebiete und die Kanalgebiete durchtrennen, die Bitleitungen jedoch nicht durchtrennen. Die zweiten Gräben werden mit einer zweiten Isolationsstruktur versehen. Anschließend werden die erste Isolationsstruktur und die zweite Isolationsstruktur selektiv zu dem Halbleitermaterial geätzt, bis an den Flanken der ersten Gräben und der zweiten Gräben die Oberfläche der dotierten Gebiete für die Kanalgebiete und die ersten Source/Drain-Gebiete freigelegt sind. Es wird ein Gateoxid gebildet. Anschließend wird zur Bildung der Gateelektroden eine dotierte Polysiliziumschicht mit im wesentlichen konformer Kantenbedeckung erzeugt.

Die ersten Gräben werden mit einer kleineren Weite als die zweiten Gräben erzeugt. Die Dicke der Polysiliziumschicht wird so bemessen, daß die Polysiliziumschicht die ersten Gräben auffüllt, die zweiten Gräben jedoch nicht auffüllt. Durch anisotropes Rückätzen der Polysiliziumschicht wird in den zweiten Gräben die Oberfläche der zweiten Isolationsstruktur teilweise freigelegt. An den Flanken der zweiten Gräben verbleiben dabei dotierte Polysiliziumspacer. Bei diesem anisotropen Rückätzen wird das in den ersten Gräben verbliebene Polysilizium zwar ebenfalls angegriffen, die Oberfläche der ersten Isolationsstrukturen in den ersten Gräben bleiben jedoch mit dotiertem Polysilizium bedeckt. Auf diese Weise ergeben sich die Gateelektroden als ringförmige Strukturen aus dotiertem Polysilizium, wobei der jeweils in den ersten Gräben angeordnete Teil der Struktur zwei benachbarten Gateelektroden angehört und diese herstellungsgemäß miteinander verbindet.

Die Gateelektroden werden schließlich mit einer dritten Isolationsstruktur abgedeckt. Die dritte Isolationsstruktur füllt die ersten Gräben und die zweiten Gräben oberhalb der Gateelektroden im wesentlich vollständig auf. In den zweiten Gräben isoliert die dritte Isolationsstruktur an gegenüberliegenden Flanken angeordnete Gateelektroden. Anschließend wird das Kondensatordielektrikum und die Kondensatorplatte aufgebracht. Die dritte Isolationsstruktur wird vorzugsweise ebenfalls durch Abscheidung einer Schicht mit im wesentlichen konformer Kantenbedeckung und Rückätzen der Schicht erzeugt.

Zur selbstjustierenden Herstellung ist es wesentlich, daß sich die Weiten der ersten Gräben und der zweiten Gräben unterscheiden, so daß die Polysiliziumschicht die ersten Gräben auffüllt, die zweiten Gräben jedoch nicht. Dadurch wird die Strukturierung der Gateelektroden, die gleichzeitig die Wortleitungen bilden, ohne photolithographische Schritte ermöglicht. In diesem Verfahren werden nur zwei photolithographische Schritte benötigt: die Ätzung der ersten Gräben und die Ätzung der zweiten Gräben erfolgt jeweils mit einer Grabenmaske. Diese Grabenmasken sind bezüglich ihrer Justierung jedoch völlig unkritisch.

Es ist besonders vorteilhaft, zur Ätzung der ersten Gräben eine erste Grabenmaske zu verwenden, die folgendermaßen hergestellt wird: Es wird eine erste SiO₂-Schicht abgeschieden und mit Hilfe photolithographischer Verfahren strukturiert. Darauf wird eine zweite SiO₂-Schicht mit im wesentlichen konformer Kantenbedeckung abgeschieden und anisotrop geätzt, so daß an Flanken der strukturierten ersten SiO₂-Schicht SiO₂-Spacer entstehen, durch die die Weite der ersten Gräben definiert wird. Auf diese Weise ist es möglich, die ersten Gräben mit einer Weite herzustellen, die geringer ist, als es der minimal herstellbaren Strukturgröße F in der jeweiligen Technologie entspricht. Auf diese Weise kann die Weite der zweiten Gräben eine minimale Strukturgröße F, zum Beispiel 0,25 µm, in der jeweiligen Technologie betragen, die Weite der ersten Gräben kann um zwei mal die Spacerbreite geringer sein, da die in der ersten SiO₂-Schicht erzeugten Strukturen ebenfalls durch die minimale Strukturbreite F begrenzt sind. Dadurch läßt sich die DRAM-Zellenanordnung mit einem Platzbedarf pro Speicherzelle von 4F² herstellen.

Es liegt im Rahmen der Erfindung, die Gebiete für die Source/Drain-Gebiete und das Kanalgebiet sowie die Bitleitungen als ganzflächige Schichten epitaktisch aufzuwachsen. Dabei kann, bei Verwendung eines Substrats, das im Bereich der DRAM-Zellenanordnung monokristallines Silizium umfaßt, zur Verbesserung der Leitfähigkeit der Bitleitungen unter den zweiten Source/Drain-Gebieten eine leitfähige Schicht aus epitaktisch aufgewachsenem CoSi₂ erzeugt werden. Diese leitfähige Schicht wird bei der Ätzung der ersten Gräben ebenfalls durchtrennt und ist Bestandteil der Bitleitungen.

Im folgenden wird die Erfindung anhand der Figuren und eines Ausführungsbeispiels näher erläutert.
- Figur 1: zeigt ein Halbleitersubstrat mit einer ersten, strukturierten SiO₂-Schicht.
- Figur 2: zeigt das Halbleitersubstrat nach Bildung einer ersten Grabenmaske und Ätzung erster Gräben.
- Figur 3: zeigt einen Schnitt senkrecht zu dem in Figur 2 gezeigten Schnitt durch das Halbleitersubstrat nach der Ätzung zweiter Gräben und Auffüllung der zweiten Gräben.
- Figur 4: zeigt den in Figur 3 gezeigten Schnitt durch das Halbleitersubstrat nach der Bildung eines Gateoxids und der Abscheidung einer dotierten Polysiliziumschicht.
- Figur 5: zeigt den in Figur 4 gezeigten Schnitt durch das Halbleitersubstrat nach Bildung der Gateelektrode und Fertigstellung der Speicherkondensatoren.
- Figur 6: zeigt den in Figur 5 mit VI-VI bezeichneten Schnitt durch das Halbleitersubstrat.
- Figur 7: zeigt den in Figur 6 mit VII-VII bezeichneten Schnitt durch das Halbleitersubstrat.

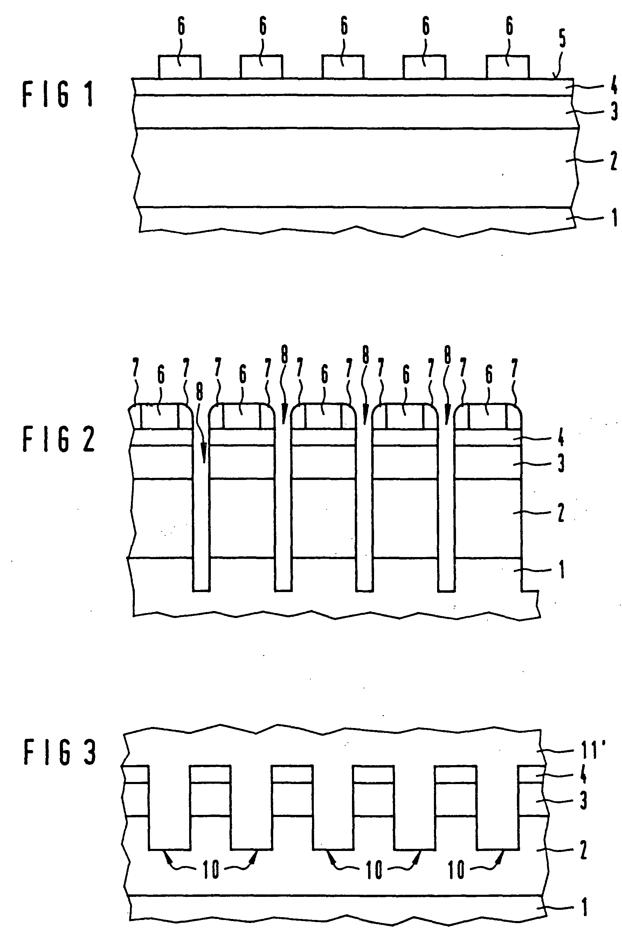

Ausgangsmaterial ist ein Substrat mit einem Bereich aus zum Beispiel p-dotiertem, monokristallinem Silizium mit einer Dotierstoffkonzentration von zum Beispiel 10¹⁷ cm⁻³, das mit einer ersten Schicht 2 aus n⁺-dotiertem Silizium mit einer Dotierstoffkonzentration von zum Beispiel 10²⁰ cm⁻³, mit einer zweiten Schicht 3 aus p-dotiertem Silizium mit einer Dotierstoffkonzentration von zum Beispiel 3 x 10¹⁷ cm⁻³ und einer dritten Schicht 4 aus n⁺-dotiertem Silizium mit einer Dotierstoffkonzentration von zum Beispiel 10²¹ cm⁻³ versehen ist (siehe Figur 1). Die erste Schicht 2, die zweite Schicht 3 und die dritte Schicht 4 werden vorzugsweise durch epitaktisches Aufwachsen erzeugt. Die dritte Schicht 4 bildet eine Hauptfläche 5 des Substrats. Die erste Schicht 2 weist eine Dicke von zum Beispiel 500 nm, die zweite Schicht 3 eine Dikke von zum Beispiel 200 nm und die dritte Schicht 4 eine Dikke von zum Beispiel 100 nm auf.

Auf die Hauptfläche 5 wird eine erste SiO₂-Schicht 6 aufgebracht und strukturiert. Die erste SiO₂-Schicht 6 wird zum Beispiel in einem TEOS-Verfahren in einer Dicke von 150 nm abgeschieden. Zur Strukturierung der ersten SiO₂-Schicht 6 wird eine Photolackmaske (nicht dargestellt) verwendet. Die Strukturierung erfolgt in einem Trockenätzprozeß. Dabei wird die Hauptfläche 5 freigelegt.

Nach Entfernen der Photolackmaske werden an senkrechten Flanken der strukturierten ersten SiO₂-Schicht 6 SiO₂-Spacer 7 gebildet. Dazu wird eine zweite SiO₂-Schicht in einem TEOS-Verfahren in einer Schichtdicke von zum Beispiel 80 nm abgeschieden. Durch anisotropes Trockenätzen selektiv zu Silizium werden aus der zweiten SiO₂-Schicht die Spacer 7 gebildet (siehe Figur 2).

Unter Verwendung der strukturierten ersten SiO₂-Schicht 6 und der SiO₂-Spacer 7 werden in einem anisotropen Trockenätzprozeß erste Gräben 8 geätzt. Als Ätzprozeß ist zum Beispiel HBr, NF₃, He, O₂ geeignet. Die ersten Gräben 8 werden mit einer Tiefe von zum Beispiel 1000 nm erzeugt. Damit reichen die ersten Gräben 8 bis in den p-dotierten Bereich 1 des Halbleitersubstrats. Die ersten Gräben 8 durchtrennen die erste Schicht 2, die zweite Schicht 3 und die dritte Schicht 4. Parallel zur Hauptfläche 5 weisen die ersten Gräben 8 einen streifenförmigen Querschnitt auf. Die ersten Gräben 8 verlaufen im wesentlichen parallel über das gesamte Zellenfeld. Die ersten Gräben 8 weisen eine Weite von zum Beispiel 90 nm und eine Länge von 64 µm auf. Der Abstand zwischen den Mitten benachbarter erster Gräben 8 beträgt zum Beispiel 500 nm, das entspricht zweimal der minimalen Strukturgröße F = 250 nm in der verwendeten Technologie.

Durch naßchemisches Ätzen zum Beispiel mit NH₄F(30%)/HF(6%) werden anschließend die strukturierte erste SiO₂-Schicht 6 und die SiO₂-Spacer 7 entfernt.

Durch Abscheidung einer weiteren SiO₂-Schicht in einem TEOS-Verfahren mit einer Schichtdicke von 100 nm werden die ersten Gräben 8 mit einer ersten Isolationsstruktur 9 aufgefüllt. Zur Bildung der ersten Isolationsstruktur 9 wird die SiO₂-Schicht rückgeätzt und planarisiert, bis außerhalb der Gräben 8 die Hauptfläche 5 freigelegt wird. Das Rückätzen erfolgt in einem Trockenätzprozeß, zum Beispiel mit CHF₃, O₂.

Anschließend wird eine weitere Grabenmaske mit Hilfe photolithographischer Verfahren erzeugt, die als Ätzmaske zum Ätzen zweiter Gräben 10 verwendet wird (siehe Figur 3). Zur Bildung der zweiten Gräben 10 muß ein Ätzverfahren verwendet werden, das Silizium selektiv zu SiO₂ angreift. Insbesondere ist dazu HBr, Cl₂, He, O₂ geeignet. Die zweiten Gräben 10 verlaufen zum Beispiel senkrecht zu den ersten Gräben 8 (Figur 3 zeigt einen zu Figur 2 senkrechten Schnitt durch die Anordnung). Um später Kurzschlüsse zu vermeiden, ist es wesentlich, daß bei der Ätzung der zweiten Gräben 10 das Silizium an Seitenwänden der ersten Isolationsstruktur 9 rückstandsfrei entfernt wird. Um dieses sicherzustellen kann nach dem anisotropen Trokkenätzen noch ein Naßätzschritt mit zum Beispiel Cholin angefügt werden. Die zweiten Gräben 10 werden in einer Tiefe von zum Beispiel 500 nm geätzt. Die zweiten Gräben 10 reichen bis in die erste Schicht 2 hinein, ohne diese jedoch zu durchtrennen. In der fertigen DRAM-Zellenanordnung wirkt der durchgehende Teil der ersten Schicht 2 jeweils als Bitleitung. Parallel zur Hauptfläche 5 weisen die zweiten Gräben 10 einen streifenförmigen Querschnitt auf. Sie verlaufen im wesentlichen parallel und weisen eine Weite von 250 nm und eine Länge von 128 µm auf. Der Abstand der Mitten benachbarter zweiter Gräben 10 beträgt zum Beispiel 500 nm, das heißt 2F.

Nach Entfernen der Grabenmaske werden die zweiten Gräben 10 durch Abscheidung einer SiO₂-Schicht 11' in einem TEOS-Verfahren in einer Schichtdicke von zum Beispiel 300 nm aufgefüllt.

Durch anisotropes Trockenätzen, zum Beispiel mit CHF₃, O₂ wird die SiO₂-Schicht 11' rückgeätzt. Dabei werden in den zweiten Gräben 10 zweite Isolationsstrukturen 11 gebildet. Der anisotrope Trockenätzprozeß greift SiO₂ selektiv zu Silizium an. Der Ätzprozeß wird fortgesetzt, bis die Oberfläche der zweiten Isolationsstrukturen 11 400 nm unter der Hauptfläche 5 liegt. In diesem Trockenätzprozeß werden auch die ersten Isolationsstrukturen 9 angegriffen, deren Oberfläche nach dem Trockenätzprozeß in der gleichen Höhe wie die der zweiten Isolationsstruktur 11 liegt. Bei dem Rückätzen werden in den ersten Gräben 8 und in den zweiten Gräben 10 die an die Flanken des jeweiligen Grabens angrenzenden Oberflächen der dritten Schicht 4 und der zweiten Schicht 3 vollständig freigelegt. Falls erforderlich kann dieses durch einen zusätzlichen Naßätzschritt, zum Beispiel mit HF(1%) sichergestellt werden.

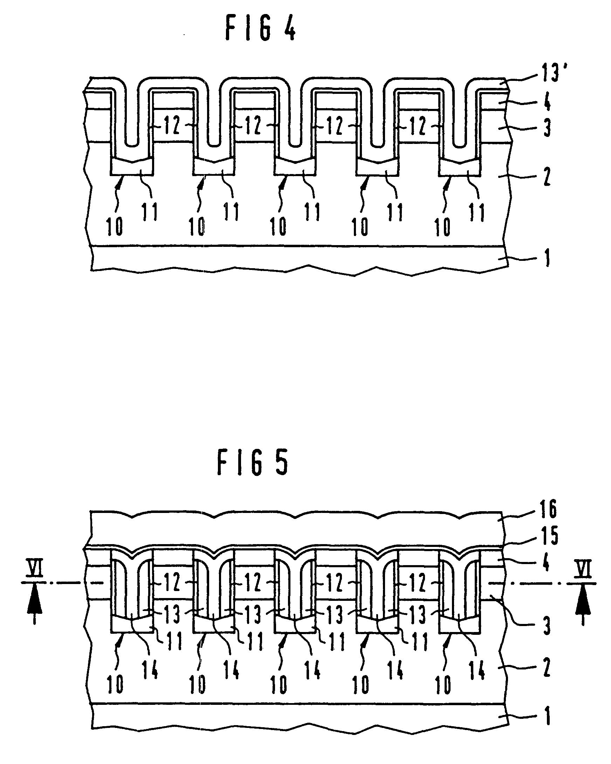

Zur Bildung eines Gateoxids 12 an der Oberfläche der zweiten Schicht 3 wird anschließend eine thermische Oxidation bei zum Beispiel 800°C durchgeführt. Das Gateoxid 12 wird in einer Dicke von zum Beispiel 5 nm gebildet. Bei der thermischen Oxidation bildet sich an allen freiliegenden Siliziumoberflächen eine 5 nm dicke SiO₂-Schicht. Schließlich wird eine in situ dotierte Polysiliziumschicht 13' abgeschieden. Die dotierte Polysiliziumschicht, die zum Beispiel durch Phosphor n-dotiert ist mit einer Dotierstoffkonzentration von 10²¹-cm⁻³, wird in einer Dicke von 80 nm abgeschieden (siehe Figur 4). Die dotierte Polysiliziumschicht 13' wird mit konformer Kantenbedeckung abgeschieden. Dadurch werden die zweiten Gräben 10 nicht aufgefüllt. Die ersten Gräben 8, die eine geringere Weite als die zweiten Gräben 10 aufweisen, werden dabei jedoch aufgefüllt.

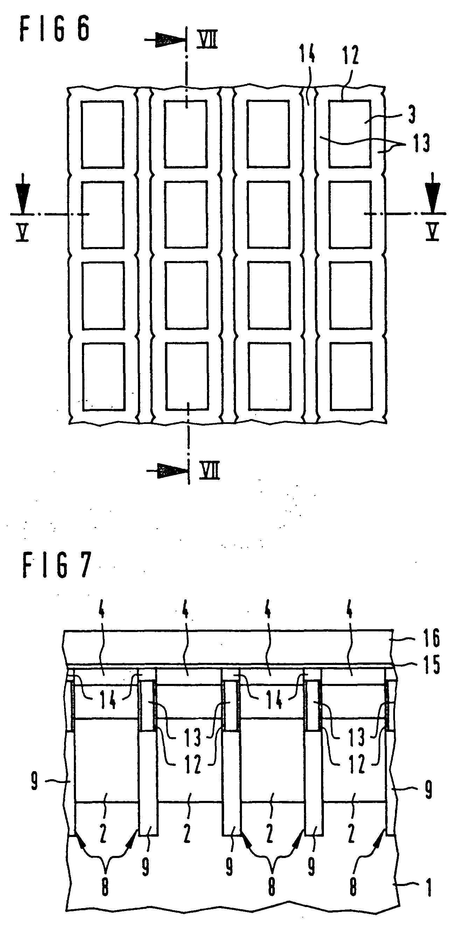

Zur Bildung von Gateelektroden 13 wird die dotierte Polysiliziumschicht 13' in einem anisotropen Trockenätzprozeß rückgeätzt. Dabei wird in den zweiten Gräben 10 die Oberfläche der zweiten Isolationsstruktur 11 freigelegt. Der in den zweiten Gräben 10 angeordnete Teil der Gateelektroden 13 entsteht als Spacer entlang der Flanken der zweiten Gräben 10. Die anisotrope Ätzung erfolgt zum Beispiel mit HBr, Cl₂, He, O₂, wobei eine Polysiliziumdicke von 150 nm geätzt wird. Das heißt, die Ätzung ist stark überzogen, so daß die mit Gateoxid bedeckten Flanken der dritten Schicht 4 im Bereich der zweiten Gräben 10 freigelegt werden (siehe Figur 5). Die bei der Gateoxidation gebildete dünne SiO₂-Schicht an der Oberfläche der dritten Schicht 4 im Bereich der Hauptfläche 5 wirkt bei dem anisotropen Ätzen als Ätzstop.

Bei der anisotropen Ätzung zur Bildung der Gateelektroden 13 wird die dotierte Polysiliziumschicht 13' in den ersten Gräben 8, die von der dotierten Polysiliziumschicht 13' aufgefüllt sind, bis unterhalb der Höhe der Hauptfläche 5 rückgeätzt (siehe Figur 7). Die Gateelektroden 13 umgeben jeweils ein durch zwei benachbarte erste Gräben und zwei benachbarte zweite Gräben begrenztes Teil der zweiten Schicht 3 ringförmig (siehe Figur 6). Wegen der geringen Weite der ersten Gräben 8 sind benachbarte Gateelektroden 13 über den im jeweiligen ersten Graben 8 angeordneten Teil miteinander verbunden.

Es wird eine weitere SiO₂-Schicht in einem TEOS-Verfahren in einer Schichtdicke von zum Beispiel 150 nm abgeschieden und in einem Trockenätzverfahren anisotrop rückgeätzt. Dadurch werden dritte Isolationsstrukturen 14 erzeugt. Die dritten Isolationsstrukturen 14 isolieren Gateelektroden 13, die an gegenüberliegenden Flanken ein- und desselben zweiten Grabens 10 angeordnet sind, gegeneinander (siehe Figur 5). In den ersten Gräben decken die dritten Isolationsstrukturen 14 die Gateelektroden 13 ab. Die zweiten Gräben 10 werden ebenfalls durch die dritten Isolationsstrukturen 14 im wesentlichen aufgefüllt. Es verbleibt lediglich eine geringe Unebenheit, die durch Abscheidung der SiO₂-Schicht in größerer Dicke vermieden werden kann.

Anschließend wird ein Kondensatordielektrikum 15 aufgebracht. Das Kondensatordielektrikum 15 wird aus einem Material mit hoher relativer Dielektrizitätskonstante εᵣ erzeugt. Vorzugsweise wird das Kondensatordielektrikum 15 aus Barium-Strontium-Titanat, Strontium-Titanat oder Blei-Zirkon-Titanat gebildet. Diese ferroelektrischen und paraelektrischen Schichten werden zum Beispiel durch Sputtern, im CVD-Verfahren oder Sol-Gel-Verfahren aufgebracht. Das Kondensatordielektrikum 15 wird in einer Schichtdicke von zum Beispiel 50 nm erzeugt.

In Fällen, in denen eine Beeinträchtigung des Siliziums der dritten Schicht 4 durch das Material des Kondensatordielektrikums 15 zu befürchten ist, liegt es im Rahmen der Erfindung, zwischen der dritten Schicht 4 und dem Kondensatordielektrikum 15 eine Zwischenschicht aus zum Beispiel TiN, Pt, W oder RuO₂ vorzusehen.

Für den Fall, daß Leckströme in dem Kondensatordielektrikum für eine Speicheranwendung nicht hinnehmbar sind, kann das Kondensatordielektrikum strukturiert werden. Dazu ist jedoch eine zusätzliche Maske erforderlich.

Auf das Kondensatordielektrikum wird ganzflächig eine Kondensatorplatte 16 aufgebracht. Dazu wird eine leitfähige Schicht, zum Beispiel aus TiN, Pt, W, RuO₂ oder n⁺-dotiertem Polysilizium abgeschieden. Die Kondensatorplatte 16 wird in einer Dicke von zum Beispiel 100 nm gebildet.

In der DRAM-Zellenanordnung umfaßt jede Speicherzelle einen Auslesetransistor, der aus dem vertikalen MOS-Transistor, der jeweils durch benachbarte erste Gräben und benachbarte zweite Gräben begrenzt ist und den dort angeordneten Teil der ersten Schicht 2 als Source/Drain-Gebiet, der zweiten Schicht 3 als Kanalgebiet und der dritten Schicht 4 als Source/Drain-Gebiet umfaßt. Der durchgehende Teil der ersten Schicht 2 (siehe Figur 5) wirkt als Bitleitung. Senkrecht zur Bitleitungsrichtung benachbarte Gateelektroden 13, die im Bereich der ersten Gräben 8 miteinander verbunden sind, bilden vergrabene Wortleitungen. Benachbarte Wortleitungen sind durch die dritte Isolationsstruktur gegeneinander isoliert. Die Speicherzellen umfassen ferner einen Speicherkondensator, der aus dem jeweiligen Teil der dritten Schicht 4 als Speicherknoten, dem Kondensatordielektrikum 15 und der Kondensatorplatte 17 gebildet wird.

Zur Herstellung der DRAM-Zellenanordnung sind nur zwei Masken erforderlich: die erste Maske zur Strukturierung der ersten SiO₂-Schicht 6, die zweite Maske zum Ätzen der zweiten Gräben 10. Werden die Strukturen in beiden Masken entsprechend der minimal herstellbaren Strukturgröße F in der jeweiligen Technologie hergestellt, so ergibt sich pro Speicherzelle ein Platzbedarf von 4F². Bei Zugrundelegen einer Technologie mit F = 0,25 µm ergibt sich ein Platzbedarf pro Speicherzelle von 0,25 µm². Die beiden verwendeten Masken sind bezüglich ihrer Justierung unkritisch. Zur Strukturierung der Gateelektroden und damit der Wortleitung ist keine weitere Maske erforderlich.

### Bezugszeichenliste

- 1: Substrat
- 2: erste Schicht
- 3: zweite Schicht
- 4: dritte Schicht
- 5: Hauptfläche
- 6: strukturierte, erste SiO₂-Schicht
- 7: SiO₂-Spacer
- 8: erste Gräben
- 9: erste Isolationsstruktur
- 10: zweite Gräben
- 11': SiO₂-Schicht
- 11: zweite Isolationsstruktur
- 12: Gateoxid
- 13': dotierte Polysiliziumschicht
- 13: Gateelektrode
- 14: dritte Isolationsstruktur
- 15: Kondensatordielektrikum
- 16: Kondensatorplatte

## Patentansprüche

1. Verfahren zur Herstellung einer DRAM-Zellenanordnung,
- bei dem Speicherzellen mit jeweils einem Auslesetransistor und einem Speicherkondensator erzeugt werden,
- bei dem die Auslesetransistoren als vertikale MOS-Transistoren in dem Halbleitersubstrat gebildet werden, deren erstes Source/Drain-Gebiet (4) jeweils an eine Hauptfläche (5) des Halbleitersubstrats angrenzt,
- bei dem die Speicherkondensatoren jeweils mit einem Speicherknoten erzeugt werden, der mit einem der ersten Source/Drain-Gebiete (4) elektrisch verbunden wird,
- bei dem in einem Halbleitersubstrat, das eine erste Schicht (2), die von einem ersten Leitfähigkeitstyp dotiert ist, eine zweite Schicht (3), die von einem zweiten, zum ersten entgegengesetzten Leitfähigkeitstyp dotiert ist, und eine dritte Schicht (4), die vom ersten Leitfähigkeitstyp dotiert ist und die an die Hauptfläche (5) angrenzt, umfaßt, erste Gräben (8), die jeweils streifenförmig sind und im wesentlichen parallel verlaufen und die die erste Schicht (2), die zweite Schicht (3) und die dritte Schicht (4) durchtrennen, geätzt werden,
- bei dem die ersten Gräben (8) mit einer ersten Isolationsstruktur (9) aufgefüllt werden,
- bei dem zweite Gräben (10), die jeweils streifenförmig sind und im wesentlichen parallel verlaufen, die die ersten Gräben (8) kreuzen und die bis in die erste Schicht (2) hineinreichen, ohne die erste Schicht (2) zu durchtrennen, geätzt werden, so daß zwischen benachbarten ersten Gräben (8) angeordnete Teile der ersten Schicht (2) vergrabene Bitleitungen (2) bilden,
- bei dem die zweiten Gräben (10) mit einer zweiten Isolationsstruktur (11) versehen werden,
- bei dem die Weite der zweiten Gräben (10) größer als die Weite der ersten Gräben (8) ist,
- bei dem die ersten Isolationsstrukturen (9) und die zweiten Isolationsstrukturen (11) selektiv zu dem Halbleitermaterial geätzt werden, bis an den Flanken der ersten Gräben (8) und der zweiten Gräben (10) die Oberfläche der strukturierten zweiten Schicht (3) und dritten Schicht (4) freigelegt sind,
- bei dem ein Gateoxid (12) gebildet wird, das mindestens die freiliegende Oberfläche der zweiten Schicht (3) bedeckt,
- bei dem zur Bildung von Gateelektroden (13) eine dotierte Polysiliziumschicht (13') mit im wesentlichen konformer Kantenbedeckung erzeugt wird, deren Dicke so bemessen wird, daß sie die ersten Gräben (8) auffüllt, die zweiten Gräben (10) jedoch nicht auffüllt, und die anisotrop rückgeätzt wird, so daß an den Flanken der zweiten Gräben dotierte Polysiliziumspacer entstehen und in den zweiten Gräben die Oberfläche der zweiten Isolationsstrukturen (11) teilweise freigelegt wird, während die Oberfläche der ersten Isolationsstruktur in den ersten Gräben (8) von dotiertem Polysilizium bedeckt bleibt, so daß in Richtung der zweiten Gräben benachbarte Gateelektroden (13) aneinandergrenzen,
- bei dem eine dritte Isolationsstruktur (14) erzeugt wird, die die Gateelektroden (13) abdeckt.

2. Verfahren nach Anspruch 1,
- bei dem zur Ätzung der ersten Gräben (8) eine erste Grabenmaske verwendet wird,
- bei dem zur Bildung der ersten Grabenmaske eine erste SiO₂-Schicht (6) abgeschieden und mit Hilfe photolithographischer Verfahren strukturiert wird,
- bei dem eine zweite SiO₂-Schicht mit im wesentlichen konformer Kantenbedeckung abgeschieden und anisotrop rückgeätzt wird, so daß an Flanken der strukturierten ersten SiO₂-Schicht (6) SiO₂-Spacer (7) entstehen, durch die die Weite der ersten Gräben (8) definiert wird.

3. Verfahren nach einem der Ansprüche 1 oder 2,
- bei dem das Halbleitersubstrat mindestens im Bereich der DRAM-Zellenanordnung monokristallines Silizium umfaßt,
- bei dem die erste Schicht (2), die zweite Schicht (3) und die dritte Schicht (4) epitaktisch aufgewachsen werden.

4. Verfahren nach Anspruch 3,
bei dem unter der ersten Schicht (2) eine leitfähige Schicht aus epitaktisch aufgewachsenem CoSi₂ erzeugt wird, die bei der Ätzung der ersten Gräben (8) durchtrennt wird.

5. Verfahren nach einem der Ansprüche 1 bis 4,
bei dem zur Bildung der Speicherkondensatoren oberhalb der ersten Source/Drain-Gebiete (4) ein Kondensatordielektrikum (15) und eine Kondensatorplatte (16) aufgebracht werden, so daß die ersten Source/Drain-Gebiete (4) gleichzeitig als Speicherknoten wirken.

6. Verfahren nach Anspruch 5,
bei dem das Kondensatordielektrikum (15) aus einem der Stoffe Barium-Strontium-Titanat, Strontium-Titanat oder Blei-Zirkon-Titanat gebildet wird.

7. Verfahren nach Anspruch 5 oder 6,
bei dem das Kondensatordielektrikum (15) als durchgehende Schicht gebildet wird.

## Claims

1. Process for the production of a DRAM cell arrangement,
- in which storage cells each having a read-out transistor and a storage capacitor are produced,
- in which the read-out transistors are formed as vertical MOS transistors in the semiconductor substrate, each first source/drain region (4) of which adjoins a main surface (5) of the semiconductor substrate,
- in which each storage capacitor is produced with a memory node which is electrically connected to one of the first source/drain regions (4),
- in which in a semiconductor substrate which comprises a first layer (2), which is doped with a first conductivity type, a second layer (3), which is doped with a second conductivity type that is the opposite of the first, and a third layer (4) which is doped with the first conductivity type and adjoins the main surface (5), first trenches (8), which are each strip-shaped, extend essentially parallel and cut through the first layer (2), the second layer (3) and the third layer (4), are etched,
- in which the first trenches (8) are filled with a first insulation structure (9),
- in which second trenches (10), which are each strip-shaped, extend essentially parallel, cross the first trenches (8) and extend into the first layer (2) without cutting through the first layer (2), are etched, so that parts of the first layer (2) which are arranged between neighbouring first trenches (8) form buried bit lines (2),
- in which the second trenches (10) are provided with a second insulation structure (11),
- in which the width of the second trenches (10) is greater than the width of the first trenches (8),
- in which the first insulation structures (9) and the second insulation structures (11) are etched selectively with respect to the semiconductor material, until the surfaces of the structured second layer (3) and third layer (4) are exposed at the sides of the first trenches (8) and of the second trenches (10),
- in which a gate oxide (12) which covers at least the exposed surface of the second layer (3) is formed,
- in which, in order to form the gate electrodes (13), a doped polysilicon layer (13') with essentially conformal edge coverage is produced, the thickness of which is dimensioned in such a way that it fills the first trenches (8), but does not fill the second trenches (10), and which is anisotropically etched back so that doped polysilicon spacers are produced at the sides of the second trenches and the surface of the second insulation structures (11) is partially exposed in the second trenches, whereas the surface of the first insulation structure remains covered by doped polysilicon in the first trenches (8) so that neighbouring gate electrodes (13) in the direction of the second trenches adjoin one another,
- in which a third insulation structure (14) which covers the gate electrodes (13) is produced.

2. Process according to Claim 1,
- in which a first trench mask is used for etching the first trenches (8),
- in which, in order to form the first trench mask, a first SiO₂ layer (6) is deposited and is structured with the aid of photolithographic processes,
- in which a second SiO₂ layer with essentially conformal edge coverage is deposited and is anisotropically etched back so that SiO₂ spacers (7), by which the width of the first trenches (8) is defined, are produced at sides of the structured first SiO₂ layer (6).

3. Process according to one of Claims 1 or 2,
- in which the semiconductor substrate comprises monocrystalline silicon at least in the region of the DRAM cell arrangement,
- in which the first layer (2), the second layer (3) and the third layer (4) are epitaxially grown.

4. Process according to Claim 3, in which a conductive layer of epitaxially grown CoSi₂, which is cut through during etching of the first trenches (8), is produced under the first layer (2).

5. Process according to one of Claims 1 to 4, in which, in order to form the storage capacitors, a capacitor dielectric (15) and a capacitor plate (16) are applied above the first source/drain regions (4), so that the first source/drain regions (4) simultaneously act as memory nodes.

6. Process according to Claim 5, in which the capacitor dielectric (15) is formed by one of the materials barium strontium titanate, strontium titanate or lead zirconate titanate.

7. Process according to Claim 5 or 6, in which the capacitor dielectric (15) is formed as a continuous layer.

## Revendications

1. Procédé de fabrication d'un agencement de cellules de DRAM,
- dans lequel des cellules de mémoire présentant chacune un transistor de lecture et un condensateur de mémoire sont créés,
- dans lequel les transistors de lecture sont formés dans le substrat semi-conducteur comme transistors MOS verticaux dont le premier domaine (4) de source/drain est chaque fois adjacent à une surface principale (5) du substrat semi-conducteur,
- dans lequel les condensateurs de mémoire sont chacun créés avec un noeud de mémoire qui est relié électriquement à l'un des premiers domaines de source/drain (4),
- dans lequel, dans un substrat semi-conducteur qui comprend une première couche (2) qui est dopée d'un premier type de conductivité, on grave une deuxième couche (3) qui est dopée par un deuxième type de conductivité opposé au premier et une troisième couche (4) qui est dopée par le premier type de conductivité et qui est adjacente à la surface principale (5), des premiers sillons (8) qui sont chacun en forme de ruban et qui s'étendent essentiellement en parallèle et séparent la première couche (2), la deuxième couche (3) et la troisième couche (4),
- dans lequel les premiers sillons (8) sont remplis par une première structure isolante (9),
- dans lequel on grave des deuxièmes sillons (10), qui sont chacun en forme de ruban et qui s'étendent essentiellement en parallèle, qui croisent les premiers sillons (8) et qui pénètrent jusque dans la première couche (2) sans traverser la première couche (2), de sorte que des parties de la première couche (2) qui sont disposées entre des premiers sillons (8) voisins forment des conducteurs de bits (2) enfouis,
- dans lequel les deuxièmes sillons (10) sont dotés d'une deuxième structure isolante (11),
- dans lequel la largeur des deuxièmes sillons (10) est supérieure à la largeur des premiers sillons (8),
- dans lequel les premières structures isolantes (9) et les deuxièmes structures isolantes (11) sont gravées sélectivement jusqu'au matériau semi-conducteur jusqu'à ce que la surface de la deuxième couche (3) et de la troisième couche (4) structurées soient libérées sur les flancs des premiers sillons (8) et des deuxièmes sillons (10),
- dans lequel un oxyde de grille (12) est formé qui recouvre au moins la surface libre de la deuxième couche (3),
- dans lequel, pour la formation d'électrodes de grille (13), on crée une couche (13') de polysilicium dopé avec recouvrement des bords essentiellement conforme, dont l'épaisseur est dimensionnée de telle sorte qu'elle remplisse les premiers sillons (8) sans cependant remplir les deuxièmes sillons (10) et qui est regravée de manière anisotrope de telle sorte que des écarteurs en polysilicium dopé soient produits sur les flancs des deuxièmes sillons et que la surface des deuxièmes structures isolantes (11) soient partiellement libérées dans les deuxièmes sillons, tandis que la surface de la première structure isolante dans les premiers sillons (8) reste recouverte par du polysilicium dopé de telle sorte que des électrodes de grille (13) voisines soient adjacentes l'une à l'autre dans la direction des deuxièmes sillons,
- dans lequel on crée une troisième structure isolante (14) qui recouvre les électrodes de grille (13).

2. Procédé selon la revendication 1,
- dans lequel on utilise un premier masque de gravure pour la gravure des premiers sillons (8),
- dans lequel, pour la formation du premier masque de gravure, on dépose une première couche de SiO₂ (6) et on la structure à l'aide d'un procédé photolithographique,
- et dans lequel on dépose une deuxième couche de SiO₂ avec un recouvrement essentiellement conforme des bords et on la regrave de manière anisotrope de manière à obtenir des écarteurs en SiO₂ (7) qui définissent la largeur des premiers sillons (8), sur les flancs de la première couche structurée de SiO₂ (6).

3. Procédé selon l'une des revendications 1 ou 2,
- dans lequel le substrat semi-conducteur comprend du silicium monocristallin au moins dans la région de l'agencement des cellules de DRAM,
- et dans lequel la première couche (2), la deuxième couche (3) et la troisième couche (4) sont amenées à croître par épitaxie.

4. Procédé selon la revendication 3, dans lequel, en dessous de la première couche (2), une couche conductrice en COSi₂ est créée par croissance épitaxique et est traversée lors de la gravure des premiers sillons (8).

5. Procédé selon l'une des revendications 1 à 4, dans lequel, pour la formation des condensateurs de mémoire, un diélectrique de condensateur (15) et une plaque de condensateur (16) sont appliqués au-dessus des premiers domaines de source/drain (4), de sorte que les premiers domaines de source/drain (4) servent en même temps de noeuds de mémoire.

6. Procédé selon la revendication 5, dans lequel le diélectrique de condensateur (15) est formé d'un des matériaux titanate de baryum et de strontium, titanate de strontium ou titanate de plomb et de zirconium.

7. Procédé selon la revendication 5 ou 6, dans lequel le diélectrique de condensateur (15) est formé comme couche continue.
